# FASCICULE DE BREVET EUROPEEN

(11) **EP 0 352 847 B1**
(45) Date de publication et mention de la délivrance du brevet: **23.03.1994**
(21) Numéro de dépôt: 89201890.4
(22) Date de dépôt: 18.07.1989
(51) Int. Cl.: B01D 9/00

(54) **Procédé et installation pour la cristallisation d'une substance minérale**
Verfahren und Vorrichtung zum Kristallisieren eines Minerals
Process and apparatus for the crystallization of a mineral substance

(30) Priorité: 29.07.1988 FR 8810402
(43) Date de publication de la demande: 31.01.1990
(73) Titulaire: SOLVAY (Société Anonyme), B-1050 Bruxelles (BE)
(72) Inventeur: Ninane, Léon, F-54110 Dombasle-sur-Meurthe (FR); Detry, Léopold Villa Les Dragons, F-64100 Bayonne (FR)
(74) Mandataire: Anthoine, Paul

(56) Documents cités:
- DE-B- 1 258 828
- FR-A- 617 399
- FR-A- 648 701
- GB-A- 392 829
- US-A- 3 514 263

## Description

La présente invention concerne un procédé pour la cristallisation d'une substance minérale, mettant en oeuvre un lit de cristaux traversé par une solution sursaturée en la substance à cristalliser.

Il est généralement connu de préparer des cristaux de substances minérales au départ d'une solution sursaturée en la substance à cristalliser.

Dans le brevet FR-B-648701 (AKTIESELSKAPET KRYSTAL), on décrit un appareillage qui convient pour la cristallisation d'une substance minérale, dans lequel on fait circuler une solution sursaturée en la matière à cristalliser (par exemple une saumure de chlorure de sodium) de bas en haut à travers une suspension de cristaux disposée au-dessus d'une cloison perforée.

Un autre exemple d'un appareil bien connu pour la cristallisation de substances minérales est le cristalliseur "OSLO" (British Chemical Engineering, August 1971, Vol. 16, No. 8, pages 681 à 685; The Chemical Engineer, July/August 1974, pages 443 à 445; brevet britannique GB-A-418349). Cet appareil connu comprend une cuve cylindrique verticale et un tube vertical qui est disposé axialement dans la cuve et débouche au voisinage immédiat du fond de celle-ci; une chambre annulaire verticale est ainsi délimitée entre le tube axial et la paroi cylindrique de la cuve. Dans l'exploitation de cet appareil connu, on met en oeuvre, dans la chambre annulaire, un lit de cristaux que l'on fait traverser par une solution sursaturée en la substance que l'on souhaite cristalliser (par exemple une solution aqueuse sursaturée de chlorure de sodium). Cette solution est introduite dans l'appareil via le tube axial, de manière qu'elle pénètre radialement dans la chambre annulaire, près du fond de celle-ci et soumette les cristaux du lit à une rotation d'ensemble comprenant une translation ascendante le long de la paroi de la cuve et une translation descendante le long du tube axial.

Dans cet appareil connu, on vise à produire des grains cristallins réguliers de forme sphérique, dont le diamètre moyen devrait pouvoir être réglé par un choix approprié des dimensions de l'appareil et des conditions opératoires. En pratique toutefois, cet appareil connu est mal adapté à l'obtention de gros grains sphériques, du fait notamment de l'attrition générée au sein du lit de cristaux et de la rotation d'ensemble à laquelle ceux-ci sont soumis. En particulier, dans le cas du chlorure de sodium, il ne permet pas de produire des grains sphériques de diamètre supérieur à 2 ou 3 mm. Par ailleurs, le phénomène d'attrition a pour effet d'engendrer la formation de fines qui sont entraînées hors du lit par l'eau mère de la cristallisation et qu'il convient dès' lors de séparer de l'eau mère avant de recycler celle-ci dans l'appareil.

L'invention vise à remédier à cet inconvénient, en fournissant un procédé nouveau qui permet d'une part de cristalliser des grains sphériques et de plus grand diamètre et, d'autre part, de réduire la formation de fines.

En conséquence, l'invention concerne un procédé pour la cristallisation d'une substance minérale, dans lequel on met en oeuvre un lit de cristaux traversé par un courant d'une solution sursaturée en la substance à cristalliser, le lit de cristaux étant fluidisé en faisant passer la solution sursaturée à travers un distributeur que l'on dispose au-dessous du lit de cristaux et que l'on maintient à une température pour laquelle la concentration de la solution sursaturée est au maximum égale à la concentration correspondant à la saturation.

Dans le procédé selon l'invention, les cristaux du lit servent de germes pour la cristallisation de la matière minérale par désursaturation de la solution sursaturée. Ils sont généralement de petits cristaux réguliers de la substance minérale que l'on vise à cristalliser.

Le taux de sursaturation de la solution sursaturée dépend de divers paramètres, notamment de la nature de la matière minérale, de sa température et de la présence éventuelle d'impuretés solides ou dissoutes. En pratique, toutes autres choses égales, on a intérêt à réaliser un taux de sursaturation maximum, celui-ci devant toutefois être limité pour éviter des cristallisations accidentelles sur les parois de l'installation de cristallisation, en amont du lit de cristaux, ainsi que des germinations primaires et secondaires au sein de la solution.

Le moyen mis en oeuvre pour obtenir la solution sursaturée n'est pas critique. Celle-ci peut par exemple être obtenue en changeant la température ou en évaporant partiellement une solution préalablement saturée en la matière à cristalliser.

Le solvant de la solution n'est pas critique, et l'eau est généralement préférée.

La température de la solution sursaturée n'est pas critique. On a toutefois observé, en pratique, que la vitesse de croissance des cristaux du lit est d'autant plus grande que la température de la solution est élevée. Il convient toutefois que la température de la solution reste inférieure à sa température d'ébullition à la pression régnant dans la chambre de cristallisation. Par exemple, dans le cas où le procédé est appliqué à la cristallisation de chlorure de sodium, on peut avantageusement mettre en oeuvre des solutions aqueuses de chlorure de sodium présentant un degré de sursaturation compris entre 0,3 et 0,5 g/kg, à une température comprise entre 50 et 110°C. Le degré de sursaturation exprime la masse de matière minérale en excès par rapport à la masse correspondant à la saturation de la solution.

Selon l'invention, le lit de cristaux est un lit fluidisé, conformément à la définition généralement admise (Givaudon, Massot et Bensimon - "Précis de génie chimique" - Tome 1 - Berger-Levrault, Nancy - 1960, pages 353 à 370). Pour fluidiser le lit, on fait passer le courant de la solution sursaturée dans un distributeur disposé sous le lit de cristaux, conformément à la technique habituelle des réacteurs à lit fluidisé. Le distributeur est un organe fondamental des réacteurs à lit fluidisé. Il a pour fonction de diviser le courant de solution en filets, de préférence parallèles et verticaux, en lui imposant par ailleurs une perte de charge définie, réglée en fonction des dimensions du lit, de la nature des particules formant le lit et de la solution (Ind. Eng. Chem. Fundam. - 1980 - 19 - G.P. Agarwal et consorts - "Fluid mechanical description of fluidized beds. Experimental investigation of convective instabilities in bounded beds" - pages 59 à 66; John H. Perry - Chemical Engineers' Handbook - 4e édition - 1963 - McGraw-Hill book company - pages 20.43 à 20.46). Il peut par exemple être une plaque horizontale percée d'orifices régulièrement répartis, une grille ou un treillis horizontal, ou un assemblage de buses verticales.

Conformément à l'invention, on maintient le distributeur à une température uniforme pour laquelle la concentration de la solution sursaturée est inférieure ou égale à la concentration correspondant à la saturation. En d'autres termes, dans le procédé selon l'invention, la température du distributeur est différente de la température de la solution sursaturée en amont du distributeur, et elle est choisie de telle sorte que la concentration de ladite solution sursaturée soit inférieure ou égale au maximum à la concentration de la solution saturée stable à la température du distributeur (pour une même substance minérale et un même solvant que la solution sursaturée). On évite de la sorte une cristallisation de la substance minérale sur le distributeur. Le choix de la température du distributeur est critique et dépend de la substance minérale que l'on cherche à cristalliser, du solvant de la solution et du degré de sursaturation. C'est ainsi que, dans le cas d'une substance dont la solubilité dans le solvant croît avec la température (par exemple une solution aqueuse de chlorure de sodium ou de potassium), la température doit être supérieure à celle de la solution sursaturée. Dans le cas d'une substance dont la solubilité dans le solvant varie en sens inverse de la température (par exemple une solution aqueuse de carbonate de sodium monohydraté), la température doit être inférieure à celle de la solution sursaturée. Le choix de la température du distributeur est par ailleurs conditionné par la nécessité d'éviter qu'à son contact, la solution sursaturée subisse une variation excessive de température qui aurait pour résultat de faire chuter exagérément son taux de sursaturation. La température du distributeur doit dès lors être réglée pour que le courant de solution subisse, dans le distributeur, une variation de température insuffisante pour la désursaturer complètement. En pratique, la température du distributeur doit être déterminée dans chaque cas particulier, en fonction notamment du degré de sursaturation de la solution et de la productivité recherchée. Son choix va en outre dépendre de divers facteurs, tels que le coefficient de transmission de chaleur du distributeur, le débit et la température de la solution, ainsi que sa chaleur spécifique. La définition de la température optimum du distributeur peut être déterminée sans difficulté dans chaque cas particulier par le calcul et l'expérience.

En aval du lit de cristaux, on recueille une eau mère sensiblement saturée. Celle-ci peut être recyclée dans le procédé, après qu'on l'ait traitée pour l'amener dans un état de sursaturation. A cet effet, dans une forme d'exécution particulière du procédé selon l'invention, l'eau mère recueillie en aval du lit de cristaux est chauffée et additionnée d'une quantité complémentaire de la substance minérale, égale à celle qui a cristallisé dans le lit, puis le mélange résultant est refroidi pour reconstituer la solution sursaturée. Cette forme d'exécution du procédé s'applique spécifiquement aux substances minérales dont la solubilité dans le solvant varie dans le même sens que la température. Le chauffage de l'eau mère doit être suffisant pour que la totalité de la quantité complémentaire susdite de substance minérale s'y dissolve. Le refroidissement du mélange peut être obtenu en le faisant circuler dans un échangeur de chaleur ou en le soumettant à une détente pour l'évaporer partiellement. Lorsque le refroidissement est opéré par détente, il convient d'ajouter à l'eau mère un complément de solvant pour compenser la quantité évaporée par la détente.

Dans une seconde forme d'exécution particulière du procédé, appliquée spécifiquement aux substances minérales dont la solubilité dans le solvant varie en sens inverse de la température, on refroidit l'eau mère recueillie en aval du lit, on lui additionne une quantité complémentaire de la substance minérale, égale à celle qui a cristallisé, puis on la chauffe pour reconstituer la solution sursaturée.

L'invention concerne aussi une installation pour la cristallisation d'une substance minérale selon le procédé conforme à l'invention, comprenant une enceinte tubulaire verticale, un tube vertical disposé axialement dans l'enceinte et débouchant à proximité du fond de celle-ci, en sorte de délimiter dans l'enceinte une chambre annulaire, le tube étant raccordé, à son extrémité supérieure, à un dispositif d'alimentation d'une solution sursaturée en la substance à' cristalliser; un distributeur divise la chambre annulaire en une chambre inférieure d'admission de la solution sursaturée et une chambre supérieure de cristallisation constituant un réacteur à lit fluidisé, le distributeur étant pourvu d'un thermostat.

Dans l'installation selon l'invention, le thermostat a pour fonction de maintenir le distributeur à une température uniforme, réglée en fonction de celle de la solution sursaturée mise en oeuvre, pour éviter une cristallisation spontanée de la substance minérale, au contact du distributeur. Le thermostat peut dès lors comprendre un moyen de chauffage ou un moyen de refroidissement du distributeur, selon que l'installation est destinée au traitement de solutions sursaturées de substances minérales dont la solubilité est une fonction croissante ou une fonction décroissante de la température.

Dans une forme de réalisation avantageuse de l'installation selon l'invention, le distributeur est formé de buses verticales ou obliques joignant deux plaques transversales qu'elles traversent, les plaques joignant le tube vertical et la paroi de l'enceinte tubulaire pour délimiter une chambre reliée à une source d'un fluide caloporteur (par exemple de l'eau ou de la vapeur) constituant le thermostat.

Dans le procédé et l'installation selon l'invention, le lit fluidisé réalise une double fonction. D'une part, il constitue un milieu de cristallisation; d'autre part, il réalise une classification granulométrique des cristaux, qui se répartissent dans le lit en couches ou strates d'égale granulométrie.

Le procédé et l'installation selon l'invention permettent de cristalliser une substance minérale à l'état des grains réguliers de forme approximativement sphérique. Ceux-ci sont généralement des billes monolithiques, ce qui signifie qu'elles sont des blocs unitaires, non agglomérés, de la matière minérale. Le procédé et l'installation selon l'invention trouvent une application spécialement avantageuse pour la production de cristaux de chlorure de sodium à l'état de billes sphériques monolithiques dont le diamètre est supérieur à 3mm, par exemple compris entre 3 et 30 mm. Des cristaux de chlorure de sodium de diamètre compris entre 5 et 10 mm trouvent une application intéressante pour la production de sel à l'état de grains irréguliers et d'aspect translucide et vitreux par la technique décrite dans le document EP-A-162490 (SOLVAY & Cie).

Des particularités et détails de l'invention vont ressortir de la description suivante, en référence aux dessins annexés.
La figure 1 représente, en section transversale verticale, une forme de réalisation particulière de l'installation selon l'invention;
La figure 2 montre, à plus grande échelle, un détail de l'installation de la figure 1;
Les figures 3 et 4 sont des reproductions photographiques à l'échelle 1/1, de grains de chlorure de sodium obtenus au moyen du procédé selon l'invention.

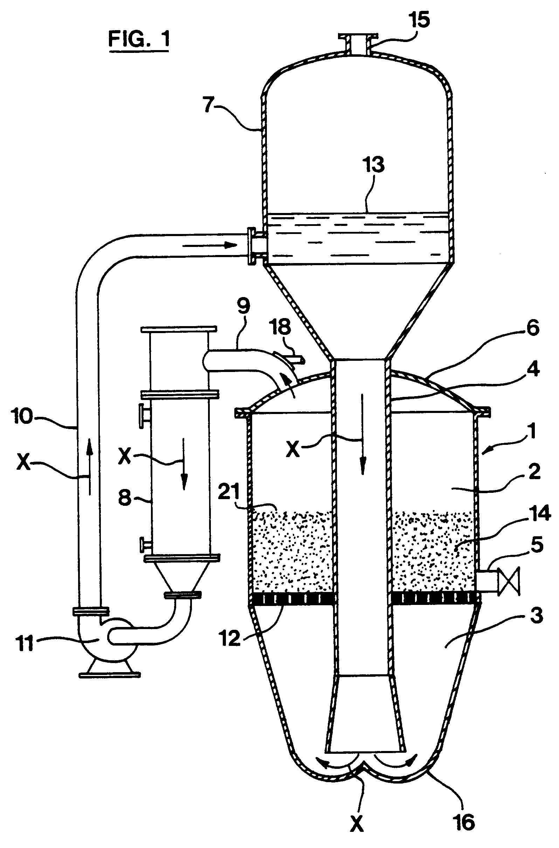

L'installation représentée à la figure 1 est un cristalliseur du type "OSLO", modifié conformément à l'invention. Il comprend une enceinte tubulaire verticale 1 dans laquelle un tube vertical 4, dont la partie inférieure est évasée, est disposé axialement. Le tube 4 délimite ainsi dans l'enceinte 1 une chambre annulaire comprenant une zone supérieure cylindrique 2 et une zone inférieure tronconique 3 dont le fond 16 a le profil d'une surface torique autour d'un cône central axial. L'enceinte 1 est obturée par un couvercle 6 traversé par le tube 4 qui débouche dans une chambre de détente 7. Un réchauffeur 8 est interposé entre le ciel de la zone supérieure 2 et la chambre de détente 7, via des conduits 9 et 10 et une pompe de circulation 11.

Conformément à l'invention, la zone supérieure 2 est destinée à contenir un lit de cristaux 14 et à être exploitée comme un réacteur à lit fluidisé. A cet effet, elle est séparée de la zone inférieure 3 par un distributeur 12 de réacteur à lit fluidisé. Dans l'installation de la figure 1, la zone supérieure annulaire 2 constitue une chambre de cristallisation et la zone inférieure annulaire 3 sert de chambre d'admission d'une solution sursaturée en une substance minérale que l'on souhaite cristalliser.

L'installation représentée à la figure 1 convient notamment pour la cristallisation de chlorure de sodium à l'état de billes sphériques. A cet effet, l'installation est remplie d'une solution aqueuse de chlorure de sodium jusqu'au niveau 13, dans la chambre de détente 7, de manière que la chambre de cristallisation 2 soit noyée. Celle-ci contient par ailleurs un lit de cristaux de chlorure de sodium 14, au-dessus du distributeur 12.

Pendant le fonctionnement de l'installation, la solution aqueuse de chlorure de sodium est mise à circuler dans le sens des flèches X par la pompe 11. A la sortie de la chambre 2, via le conduit 9, la solution saturée en chlorure de sodium traverse le réchauffeur 8, ce qui élève sa température, puis pénètre dans la chambre de détente 7, où elle est partiellement vaporisée par détente, ce qui provoque son refroidissement et sa sursaturation. La vapeur d'eau libérée est évacuée par un orifice supérieur 15 de la chambre de détente 7. La solution aqueuse sursaturée descend verticalement dans le tube 4, pénètre radialement dans la chambre 3, le long du fond torique 16, puis traverse le distributeur 12 et pénètre dans le lit de cristaux 14 qu'elle fluidise, conformément à l'invention. La solution est progressivement désursaturée pendant qu'elle traverse le lit fluidisé 14, dont les cristaux croissent en conséquence et se répartissent en couches ou strates horizontales, en fonction de leurs dimensions granulométriques. Les grosses fractions granulométriques progressent vers le bas du lit et sont évacuées périodiquement par un conduit de soutirage 5. L'eau mère de la cristallisation parvenant dans le ciel de la chambre 2 est une solution aqueuse saturée (ou légèrement sursaturée) en chlorure de sodium. Elle est recyclée dans le réchauffeur 8, via le conduit 9, où elle est additionnée d'un complément de solution aqueuse saturée de chlorure de sodium, par l'intermédiaire d'une tubulure 18. Le complément de solution aqueuse de chlorure de sodium est réglé pour compenser la quantité de chlorure de sodium qui a cristallisé dans le lit 14 et la quantité d'eau évacuée par l'évaporation dans la chambre de détente 7.

Pendant l'exploitation de l'installation, de la manière décrite ci-dessus, le distributeur 12 est chauffé de manière que sa paroi en contact avec la solution soit à une température qui est supérieure à la température de la solution sursaturée dans la zone 3, en amont du distributeur 12.

Le distributeur 12 peut être chauffé par tous moyens adéquats.

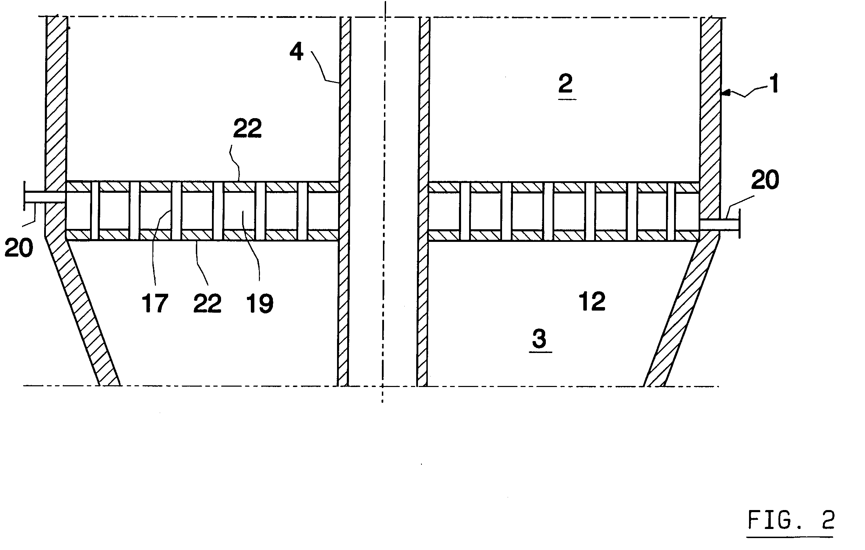

La figure 2 montre une forme de réalisation particulièrement adéquate du distributeur 12. Celui-ci est constitué de plusieurs buses verticales 17 de courte hauteur, joignant deux plaques horizontales 22 qu'elles traversent. Les plaques 22 sont interposées entre le tube axial 4 et la paroi cylindrique périphérique de la chambre supérieure 2, de sorte qu'elles délimitent une chambre annulaire 19 de faible hauteur, traversée par les buses 17. Deux tubes 20 permettent de faire circuler un fluide caloporteur dans la chambre 19, par exemple de la vapeur d'eau.

Dans l'installation représentée aux figures 1 et 2, le fond 16 est chauffé dans les mêmes conditions que celles qui sont imposées plus haut au chauffage du distributeur 12. A cet effet, il peut être doublé d'une enveloppe parcourue par un fluide chaud, généralement de la vapeur d'eau.

Dans l'installation représentée à la figure 1, la paroi périphérique de la chambre de cristallisation 2 est cylindrique, de sorte que celle-ci présente une section transversale constante sur toute sa hauteur.

Dans une forme de réalisation particulière, non représentée, de l'installation selon l'invention, la chambre de cristallisation 2 est profilée de manière que sa section transversale aille en s'élargissant du bas vers le haut, au-dessus de la surface libre 21 du lit fluidisé 14. Dans cette forme de réalisation de l'installation, l'élargissement de la zone supérieure de la chambre de cristallisation a pour fonction d'y réaliser, au-dessus du lit fluidisé 14, une vitesse de solution inférieure aux vitesses régnant dans la chambre 3. On évite de la sorte la formation d'un lit fluidisé parasite dans la chambre 3 sous le distributeur 12. Dans la zone du lit fluidisé 14, délimitée entre le distributeur 12 et la surface libre 21 du lit, la section transversale de la chambre de cristallisation 2 peut être constante ou diminuer progressivement du bas vers le haut.

Dans une autre forme de réalisation, non représentée, de l'installation selon l'invention, on interpose dans le conduit 9 un dispositif conçu pour retenir les fins cristaux qui seraient entraînés dans la solution sortant de l'enceinte 1. Ce dispositif peut par exemple consister en une chambre de décantation ou un cyclone.

L'exemple suivant sert à illustrer l'invention.

Dans la chambre de cristallisation (2) d'un appareil du type de celui-ci décrit en référence aux figures 1 et 2, on a introduit un lit d'environ 3000 kg de cristaux de chlorure de sodium de diamètre moyen compris entre 0,5 et 2 mm. On a chauffé le distributeur (12) au moyen d'un courant de vapeur à 120°C et on a introduit dans la chambre d'admission (3) une solution aqueuse sursaturée de chlorure de sodium à environ 110°C, animée d'une vitesse ascensionnelle suffisante pour fluidiser le lit de cristaux (14). Le taux de sursaturation de la solution aqueuse, à la base du lit, était d'environ 0,4 g/kg. L'eau mère recueillie à la sortie du lit a été traitée dans le réchauffeur (8) où sa température s'est élevée d'environ 1°C; on l'a envoyée dans la chambre de détente (7), où on l'a soumise à une détente réglée pour ramener sa température à environ 110°C et réaliser le taux de sursaturation initial (0,4 g/kg). La solution sursaturée a ensuite été recyclée dans la chambre d'admission (3) via le tube axial (4) comme exposé ci-dessus.

On a soutiré des cristaux de manière continue à la base du lit, à un débit proportionnel à la productivité fixée. Simultanément, on a introduit un complément de solution aqueuse saturée de chlorure de sodium dans le réchauffeur (8) en quantité réglée pour compenser le chlorure de sodium soutiré du lit et la vapeur d'eau éliminée par la détente.

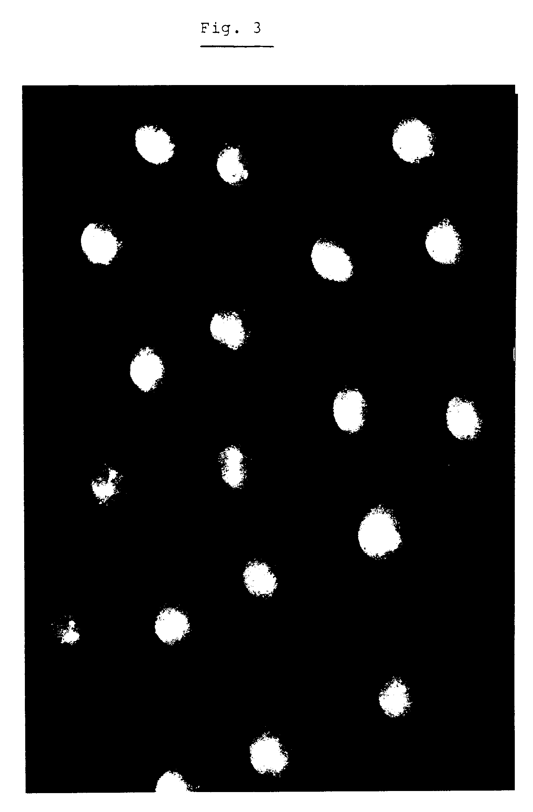

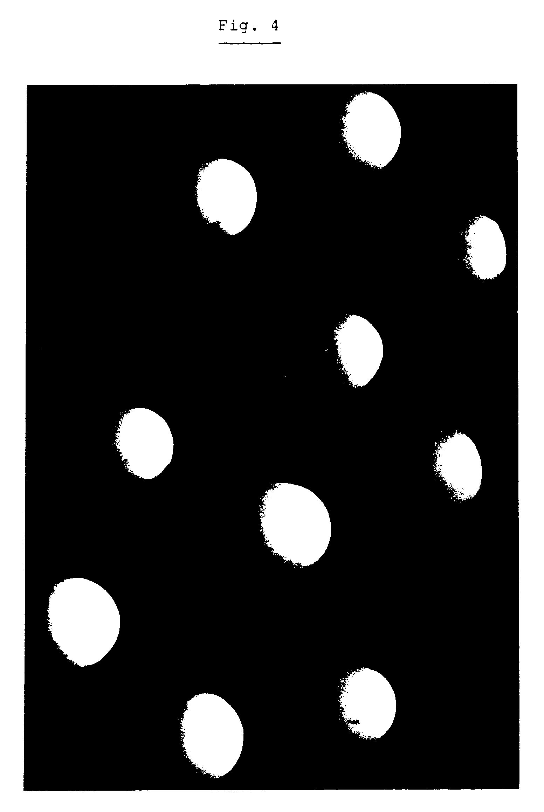

Les photographies des figures 3 et 4 montrent des cristaux obtenus dans deux phases successives de l'essai. Ces cristaux sont des grains monolithiques approximativement sphériques de chlorure de sodium, dont le diamètre est sensiblement compris entre 10 et 15 mm (Figure 3) et entre 18 et 23 mm (Figure 4).

## Revendications

1. Procédé pour la cristallisation d'une substance minérale, dans lequel on met en oeuvre un lit de cristaux traversé par un courant d'une solution sursaturée en la substance à cristalliser dans un solvant liquide, caractérisé en ce qu'on met en oeuvre un lit fluidisé de cristaux, en faisant passer le courant de solution sursaturée dans un distributeur que l'on dispose au-dessous du lit de cristaux et que l'on maintient à une température pour laquelle la concentration de la solution sursaturée est au maximum égale à la concentration correspondant à la saturation.

2. Procédé selon la revendication 1, caractérisé en ce que, dans le cas où la solubilité de la substance minérale dans le solvant de la solution sursaturée croît avec la température, on maintient le distributeur à une température supérieure à celle de la solution sursaturée.

3. Procédé selon la revendication 1 ou 2, caractérisé en ce qu'on recueille l'eau mère de la cristallisation, à la sortie du lit, on la chauffe, on y ajoute une quantité complémentaire de la substance minérale, égale à celle qui a cristallisé dans le lit, et on refroidit ensuite le mélange résultant pour reconstituer la solution sursaturée.

4. Procédé selon la revendication 3, caractérisé en ce que, pour refroidir le mélange, on le soumet à une détente pour l'évaporer partiellement et on ajoute à l'eau mère une quantité de solvant égale à celle évaporée.

5. Procédé selon la revendication 4, caractérisé en ce qu'on met en oeuvre un lit de cristaux de chlorure de sodium et une solution aqueuse saturée de chlorure de sodium.

6. Installation pour la cristallisation d'une substance minérale selon le procédé conforme à l'une quelconque des revendications 1 à 5, comprenant une enceinte tubulaire verticale (1), un tube vertical (4) disposé axialement dans l'enceinte et débouchant à proximité du fond (16) de celle-ci, en sorte de délimiter dans l'enceinte une chambre annulaire (2, 3), le tube étant raccordé, à son extrémité supérieure, à un dispositif (7) d'alimentation d'une solution sursaturée en la substance à cristalliser, caractérisée en ce qu'un distributeur (12) de réacteur à lit fluidisé divise la chambre annulaire (2, 3) en une chambre inférieure (3) d'admission de la solution sursaturée et une chambre supérieure de cristallisation (2) constituant un réacteur à lit fluidisé, le distributeur (12) étant pourvu d'un thermostat.

7. Installation selon la revendication 6, caractérisée en ce que la section transversale de la chambre de cristallisation (2) va en s'élargissant du bas vers le haut au-dessus de la surface libre (21) du lit fluidisé.

8. Installation selon la revendication 6 ou 7, caractérisée en ce que la chambre supérieure de cristallisation (2) comprend un conduit (9) d'évacuation d'une eau mère de la cristallisation vers un réchauffeur (8) qui est en communication avec une chambre de détente constituant le dispositif (7) d'alimentation de la solution sursaturée.

9. Installation selon l'une quelconque des revendications 6 à 8, caractérisée en ce que le distributeur (12) est formé de buses verticales joignant deux plaques horizontales qu'elles traversent, les plaques étant interposées entre le tube vertical (4) et la paroi de l'enceinte tubulaire (1), pour délimiter une chambre reliée à une source d'un fluide caloporteur constituant le thermostat.

## Claims

1. Process for the crystallization of an inorganic substance, in which a bed of crystals is employed, through which passes a stream of a solution supersaturated with the substance to be crystallized in a liquid solvent, characterized in that a fluidized bed of crystals is employed, by passing the stream of supersaturated solution through a distributor which is arranged below the bed of crystals and which is maintained at a temperature at which the concentration of the supersaturated solution does not exceed the concentration corresponding to saturation.

2. Process according to Claim 1, characterized in that, in the case where the solubility of the inorganic substance in the solvent of the supersaturated solution increases with temperature, the distributor is maintained at a temperature above that of the supersaturated solution.

3. Process according to Claim 1 or 2, characterized in that the crystallization mother liquor is collected on leaving the bed, is heated, a complementary quantity of the inorganic substance which is equal to that which has crystallized in the bed is added thereto, and the resulting mixture is then cooled to reconstitute the supersaturated solution.

4. Process according to Claim 3, characterized in that, to cool the mixture, it is subjected to a decompression to evaporate it partially and a quantity of solvent equal to that evaporated is added to the mother liquor.

5. Process according to Claim 4, characterized in that a bed of sodium chloride crystals and an aqueous solution saturated with sodium chloride are employed.

6. Plant for the crystallization of an inorganic subtance according to the process in accordance with any one of Claims 1 to 5, comprising a vertical tubular enclosure (1), a vertical tube (4) arranged axially in the enclosure and opening in the vicinity of the bottom (16) thereof, so as to define an annular chamber (2, 3) in the enclosure, the tube being joined at its upper end to a device (7) for feeding a solution supersaturated with the substance to be crystallized, characterized in that a fluidized bed reactor distributor (12) divides the annular chamber (2, 3) into a lower entry chamber (3) for the supersaturated solution and an upper crystallization chamber (2) forming a fluidized bed reactor, the distributor (12) being provided with a thermostat.

7. Plant according to Claim 6, characterized in that the cross-section of the crystallization chamber (2) widens from the bottom upwards above the free surface (21) of the fluidized bed.

8. Plant according to Claim 6 or 7, characterized in that the upper crystallization chamber (2) comprises a conduit (9) for removing a crystallization mother liquor towards a reheater (8) which is in communication with a decompression chamber forming the device (7) for feeding the supersaturated solution.

9. Plant according to any one of Claim 6 to 8, characterized in that the distributor (12) is made up of vertical nozzles joining two horizontal plates through which they pass, the plates being inserted between the vertical tube (4) and the wall of the tubular enclosure (1), to define a chamber connected to a source of a heat-transfer fluid forming the thermostat.

## Patentansprüche

1. Verfahren zum Kristallisieren einer mineralischen Substanz, bei dem man ein Kristallbett einsetzt, das von einem Strom einer Lösung, die an der zu kristallisierenden Substanz in einem flüssigen Lösungsmittel übersättigt ist, durchquert wird, dadurch gekennzeichnet, daß man ein Wirbelbett von Kristallen einsetzt, indem man den Strom der übersättigten Lösung einen Verteiler durchqueren läßt, der unterhalb des Kristallbettes angebracht ist, und daß man ihn auf einer Temperatur hält, für die die Konzentration der übersättigten Lösung maximal gleich der der Sättigung entsprechenden Konzentration ist.

2. Verfahren nach Anspruch 1, dadurch gekennzeichnet, daß in dem Fall, in dem die Löslichkeit der mineralischen Substanz in dem Lösungsmittel der übersättigten Lösung mit der Temperatur wächst, man den Verteiler auf einer Temperatur hält, die größer ist als die der übersättigten Lösung.

3. Verfahren nach Anspruch 1 oder 2, dadurch gekennzeichnet, daß man die Mutterlauge der Kristallisation am Ausgang des Bettes sammelt, sie erhitzt, ihr eine ergänzende Menge der mineralischen Substanz zufügt, die gleich derjenigen ist, die in dem Bett kristallisiert ist, und man dann die resultierende Mischung abkühlt, um die übersättigte Lösung wiederherzustellen.

4. Verfahren nach Anspruch 3, dadurch gekennzeichnet, daß zum Abkühlen der Mischung man sie einer Entspannung unterzieht, um sie teilweise zu verdampfen und man der Mutterlauge eine Menge an Lösungsmittel zufügt, die gleich der verdampften Menge ist.

5. Verfahren nach Anspruch 4, dadurch gekennzeichnet, daß man ein Bett von Natriumchloridkristallen und eine gesättigte, wässrige Natriumchloridlösung einsetzt.

6. Vorrichtung zum Kristallisieren einer mineralischen Substanz gemäß dem Verfahren nach einem der Ansprüche 1 bis 5, umfassend eine rohrförmige, vertikale Umhüllung (1), ein vertikales Rohr (4), das axial in der Umhüllung angebracht ist und nahe des Bodens (16) aus dieser austritt, so daß in der Umhüllung eine ringförmige Kammer (2, 3) begrenzt wird, wobei das Rohr an seinem oberen Ende mit einer Vorrichtung (7) zum Speisen einer an der zu kristallisierenden Substanz übersättigten Lösung verbunden ist, dadurch gekennzeichnet, daß ein Verteiler (12) des Wirbelbettreaktors die ringförmige Kammer (2, 3) in eine untere Kammer (3), die den Zutritt der übersättigten Lösung erlaubt, und eine obere Kristallisationskammer (2), die einen Wirbelbettreaktor bildet, teilt, wobei der Verteiler (12) mit einem Thermostat versehen ist.

7. Vorrichtung nach Anspruch 6, dadurch gekennzeichnet, daß der Querschnitt der Kristallisationskammer (2) sich von unten nach oben, oberhalb der freien Fläche (21) des Wirbelbetts, vergrößert.

8. Vorrichtung nach Anspruch 6 oder 7, dadurch gekennzeichnet, daß die obere Kristallisationskammer (2) eine Leitung (9) zum Ablassen einer Mutterlauge der Kristallisation zum Wiedererhitzer (8) umfaßt, der in Verbindung mit einer Entspannungskammer ist, die die Vorrichtung (7) zum Speisen der übersättigten Lösung bildet.

9. Vorrichtung nach einem der Ansprüche 6 bis 8, dadurch gekennzeichnet, daß der Verteiler (12) aus vertikalen Düsen gebildet ist, die zwei horizontale Platten verbinden, die sie durchqueren, wobei die Platten zwischen dem vertikalen Rohr (4) und der Seitenwand der rohrförmigen Umhüllung (1) angebracht sind, um eine Kammer, die den Thermostat darstellt, zu bilden, die mit einer Quelle einer Wärmeübertragungsflüssigkeit verbunden ist.
